# EUROPÄISCHE PATENTSCHRIFT

(11) **EP 0 513 555 B1**
(45) Veröffentlichungstag und Bekanntmachung des Hinweises auf die Patenterteilung: **30.07.1997**
(21) Anmeldenummer: 92106730.2
(22) Anmeldetag: 21.04.1992
(51) Int. Cl.: H01L 21/68, H01L 21/00, H01L 21/48

(54) **Vorrichtung zum Einbrennen von bedruckten Substraten**
Device for baking printed substrates
Dispositif pour cuire des substrats imprimés

(30) Priorität: 04.05.1991 DE 4114639
(43) Veröffentlichungstag der Anmeldung: 19.11.1992
(73) Patentinhaber: ROBERT BOSCH GMBH, 70442 Stuttgart (DE)
(72) Erfinder: Weiblen, Kurt, Ing.grad., W-7430 Metzingen 2 (DE); Irslinger, Hans-Martin, Dipl.-Ing., W-7410 Reutlingen (DE)

(56) Entgegenhaltungen:
- US-A- 4 635 788
- IBM TECHNICAL DISCLOSURE BULLETIN, Bd. 25, Nr. 11B, April 1983, New YorK US, Seiten 6161-6162; N. DALCERO et al.: 'Ceramic Boat'
- IBM TECHNICAL DISCLOSURE BULLETIN, Bd. 24, Nr. 4, September 1981, New York US, Seiten 2144-2145; J.F. FRANCIS : 'Recessed Ceramic Flattening Tile'
- IBM TECHNICAL DISCLOSURE BULLETIN, Bd. 27, Nr. 12, Mai 1985, New York US Seite 7195; 'Method to Minimize Aluminum Oxide Particle Deposition During Ceramic Firing'

## Beschreibung

### Stand der Technik

Die Erfindung betrifft eine Vorrichtung zum Einbrennen von bedruckten Substraten, insbesondere von Dickschichtsubstraten, mit einem die substrattragenden und diese durch einen Durchlaufofen befördernden Geflechtband.

Es sind Vorrichtungen bekannt, mit deren Hilfe Substrate, auch Dickschichtsubstrate eingebrannt werden können. Dabei werden einseitig auf die Substrate aufgebrachte Schichten, die vorzugsweise als Pastenschichten ausgebildet sind, eingebrannt. Derartige Schichten dienen später der Herstellung einzelner Bauteile auf dem Substrat. Zum Einbrennen dieser Schichten werden die Substrate auf ein hitzefestes Geflechtband, welches beispielsweise als Stahlgeflechtgliederband ausgebildet ist, durch einen Ofen, der beidseitig Ein- und Auslaßöffnungen aufweist, geführt. Die Transportgeschwindigkeit des Geflechtbands ist so gewählt, daß die Pastenschichten auf dem Substrat bei einer gegebenen Innentemperatur des Durchlaufofens ausreichend eingebrannt sind. Ein gitterartiges Substrattransportband ist aus US-A- 4 635 788 bekannt.

Nachteil dieser Vorrichtungen ist es, daß während des Transports des Substrats die dem Geflechtband zugewandte Oberfläche des Substrats beschädigt werden kann.

### Vorteile der Erfindung

Die erfindungsgemäße Vorrichtung mit den in Anspruch 1 genannten Merkmalen hat gegenüber dem Stand der Technik den Vorteil, daß während des Transports durch den Ofen Beschädigungen der der Geflechtband zugewandten Oberfläche des Substrats ausgeschlossen sind.

Dadurch, daß die Substrate während der Beförderung auf dem Geflechtband lediglich in ihren Kantenbereichen gehalten werden, ist es auch möglich, pelseitig beschichtete Substrate mit dieser Vorrichtung einem Einbrennvorgang zu unterwerfen.

Bevorzugt wird eine Ausführungsform der Vorrichtung, bei der die Halterungen keilförmig ausgebildet sind und einen Haltebereich aufweisen, dessen unter einem Winkel in Richtung auf das Geflechtband abfallende Fläche als Auflagefläche für das Substrat dient. Die Halterungen werden so auf dem flechtband angeordnet, daß sich jeweils die fallenden Flächen zweier gegenüberliegender Halterungen gegenüberliegen. Dabei ist es für die Funktion der Halterungen belanglos, ob die Substrate an ihren Stirn- oder Längsseiten von den Halterungen unterstützt werden.

Bevorzugt wird eine Ausführungsform der Vorrichtung, bei welcher die Halterungen mit einem rungsbereich versehen sind, der mit dem Geflechtband in Eingriff tritt. Dadurch wird eine sichere Verankerung der Halterungen auf dem Geflechtband und damit auch der von diesem gehaltenen Substrat gewährleistet.

Außerdem wird eine Ausführungsform der Vorrichtung bevorzugt, bei welcher der Sicherungsbereich der Halterung als die Maschen des Geflechtbandes durchdringender Sicherungsstift ausgebildet ist, wobei der Haltebereich so dimensioniert ist, daß er das Geflecht nicht durchdringen kann. Auf diese Weise sind die Halterungen leicht auf dem Geflechtband aufsetzbar, so daß auch nacheinander Substrate verschiedener Dimensionen dem Einbrennverfahren unterworfen werden können, wobei die Anpassung an die verschiedenen Größen rasch durchführbar ist.

Bevorzugt wird eine weitere Ausführungsform der Vorrichtung, bei welcher die Halterungen durch einen den Sicherungsstift durchdringenden Draht gesichert werden. Damit können einmal aufgesteckte Halterungen auch bei während des Transports auftretenden Vibrationen nicht aus dem Geflechtband fallen, so daß Transportschäden der Substrate mit hoher Sicherheit vermeidbar sind.

Weiterhin wird eine Ausführungsform der Vorrichtung bevorzugt, bei dem die dem Substrat zugewandte Oberfläche einer Halterung mindestens eine Rippe aufweist. Auf diese Weise läßt sich die Berührungsfläche zwischen Substrat und Halterung auf ein Minimum vermindern. Damit werden Beschädigungen durch die Halterungen, aber auch Verunreinigungen, die von der Halterung auf die Oberfläche der Substrate gelangen können, stark reduziert.

Besonders bevorzugt wird eine Ausführungsform der Vorrichtung, bei welcher die Halterungen in mehreren neben- und hintereinander angeordneten Reihen auf dem Gliederband befestigt sind. Auf diese Weise lassen sich ohne weiteres mehrere Substrate hintereinander auf dem Geflechtband durch einen Ofen führen, wobei eine Anpassung an verschiedene Größen der Substrate auch bei dieser Vorrichtung ohne weiteres verwirklicht werden kann.

Weitere Gestaltungsmöglichkeiten beziehungsweise Ausführungsformen ergeben sich aus den übrigen Unteransprüchen.

### Zeichnung

Die Erfindung wird anhand einer Zeichnung näher erläutert.

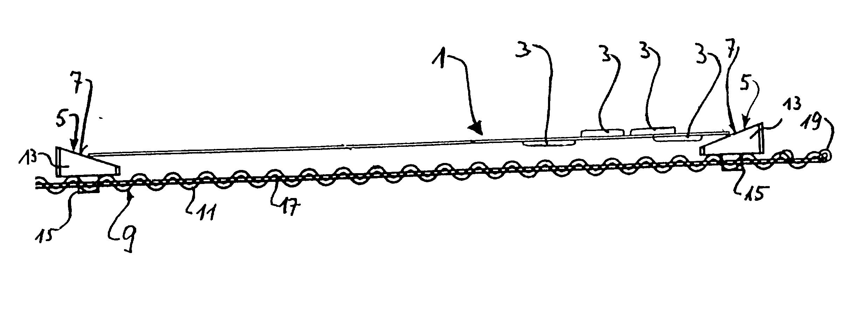

Die einzige Figur zeigt schematisch ein Geflechtband eines Durchlaufofens in Seitenansicht mit zwei ein Substrat unterstützenden Halterungen.

### Beschreibung der Ausführungsbeispiele

Durch die horizontale Doppellinie soll ein beidseitig bedrucktes Dickschichtsubstrat 1 angedeutet werden. Zur Verdeutlichung sind auf dessen Oberseite und Unterseite Pastenschichten 3 angedeutet.

An den Endbereichen des Substrats 1 sind zwei Halterungen 5 angeordnet, die auf ihrer, dem Substrat 1 zugewandten Seite eine abfallende Auflagefläche 7 für das Substrat 1 aufweisen. Unter dem Substrat 1 beziehungsweise den Halterungen 5 befindet sich ein Geflechtband 9, welches vorzugsweise als flechtsgliederband ausgebildet ist. Das Geflechtsband wird durch einen wellenförmigen Draht 11 angedeutet.

Die Halterungen 5 weisen einen Haltebereich 13 auf, auf dem das Substrat 1 aufliegt. Unterhalb des Haltebereichs 13 sind als Sicherungseinrichtung dienende Sicherungsstifte 15 erkennbar, die so dimensioniert sind, daß sie durch Maschen des Geflechtgliederbands 9 hindurchführbar sind. Die Haltebereiche 13 sind dabei größer als die Maschen ausgebildet, so daß die Halterungen nicht durch das Geflechtband 9 hindurchrutschen können. Andererseits findet aufgrund der als Sicherungsbereich dienenden Sicherungsstifte 15 eine Verankerung der Halterungen 5 auf dem Geflechtsgliederband 9 statt.

Die Halterungen 5 sind so beabstandet, daß die Endbereiche des Substrats 1 etwa in der Mitte der in Richtung auf das Geflechtband 9 abfallenden Schrägflächen 7 ruht. Dadurch ist auch bei Vibrationen sichergestellt, daß das Substrat nicht ohne weiteres von den Halterungen 5 rutschen kann. Andererseits wird das Substrat 1 in einem Abstand zu dem Geflechtband 9 gehalten, so daß die auf der Unterseite des Substrats angeordneten Pastenschichten keinesfalls mit dem Gliederband in Berührung gelangen können, wodurch Beschädigungen eintreten könnten.

Die Halterungen 5 sind zusätzlich durch einen als Verriegelungseinrichtung dienenden Draht gesichert, welcher durch geeignete Ausnehmungen in den Sicherungsstiften 15 geführt und in das Geflechtband 9 integriert ist. Der Sicherungsdraht 17 ist hier durch zwei horizontal verlaufende Linien gekennzeichnet, die den wellenförmig angeordneten Draht 11 des Geflechtbands 9 durchdringen. Am Ende des Sicherungsdrahts 17 ist eine Öse 19 angedeutet, die mit dem Endbereich des Gliederbands in Eingriff steht, so daß der Sicherungsdraht 17 unverrückbar gehalten ist
Bei einem endlosen Gliederband ist der Sicherungsdraht an dessen seitlichen Endbereichen verankert.

Je nach der Breite der Halterungen 15 und der Länge der zugehörigen Seitenkante des Substrats 1 muß die Anzahl der Halterungen an die Dimensionen des Substrats angepaßt werden. Vorzugsweise werden pro Seitenkante eines Substrats 1 zwei Halterungen 5 vorgesehen, so daß ein Verkanten des Substrats sicher vermieden wird.

Für die Funktion der Vorrichtung ist es belanglos, ob die Halterungen 5 an den Seiten- oder Längskanten eines Substrats 1 eingreifen.

Auf dem Geflechtband 9 können ohne weiteres mehrere neben- und hintereinander angeordnete Reihen von Halterungen 5 angeordnet werden, deren Abstand an die Dimensionen des zuhaltenden Substrats 1 angepaßt ist. Dabei ist es sehr leicht möglich, die Halterungen 5 in verschiedene Maschen des Gliederbandes 9 einzustecken, so daß auch Substrate schiedener Größe ohne weiteres sicher gehalten werden können. Dabei ist die Umrüstung der Vorrichtung sehr einfach möglich.

Um Beschädigungen und Verunreinigungen des Substrats 1 auf ein Minimum zu reduzieren, kann die Oberseite der Halterungen, das heißt, die in Richtung auf das Gliederband 9 abfallende Fläche 7 der etwa keilförmig ausgebildeten Halterungen 5 mit Rippen versehen werden, die beispielsweise einen dreieckförmigen Querschnitt aufweisen. Damit ergibt sich lediglich eine punktweise Berührung zwischen Substrat und Oberfläche der Halterung.

Besonders hitzebeständig und bezüglich Verunreinigungen des Substrats unbedenklich sind Keramikhalterungen, die vorzugsweise als Formpreßteile herstellbar sind. Als Keramikmaterial hat sich besonders Aluminiumoxid (Al₂O₃) bewährt.

Dadurch, daß die Substrate 1 lediglich auf die Halterungen 5 aufgelegt werden, ist eine vollautomatische Beschickung und Entladung der Vorrichtung ohne weiteres durchführbar. Einschränkungen für die Formen der Substrate sind praktisch nicht gegeben. Überdies ist die Struktur der aufgebrachten Pastenschichten auf der Rückseite des Substrats frei wählbar.

Dadurch, daß die Halterungen elektrisch isolierend ausgelegt sind, werden die Substrate 1 vor Einflüssen der Umgebung sicher geschützt.

Da die aus Keramik hergestellten Halterungen sehr leicht sind, ist auch eine dichte Bestückung der Gewebebänder ohne weiteres möglich, die Bandbelastung steigt nur unerheblich.

Nach allem ist überdies erkennbar, daß auch vorhandene Vorrichtungen einfach und kostengünstig nachgerüstet werden können.

## Patentansprüche

1. Vorrichtung zum Einbrennen von bedruckten Substraten, insbesondere von Dickschichtsubstraten, mit einem die Substrate tragenden und diese durch einen Durchlaufofen befördernden Geflechtband, **gekennzeichnet durch** in das Geflechtband (9) eingebrachte Halterungen (5) zur Unterstützung der bedruckten Substrate (1) in ihren Kantenbereichen.

2. Vorrichtung nach Anspruch 1, **dadurch gekennzeichnet**, daß die Halterungen (5) keilförmig ausgebildet sind und einen Haltebereich (13) aufweisen, dessen unter einem Winkel in Richtung auf das Geflechtband (9) abfallende Fläche (7) als Auflagefläche für das vorzugsweise beidseitig bedruckte Substrat dient.

3. Vorrichtung nach Anspruch 1 oder 2, **dadurch gekennzeichnet**, daß die Halterungen (5) mit einem mit dem Geflechtband (9) in Eingriff tretenden Sicherungsbereich (15) versehen sind.

4. Vorrichtung nach Anspruch 3, **dadurch gekennzeichnet**, daß der Sicherungsbereich als die Maschen des Geflechtsbands (9) durchdringender Sicherungsstift (15) ausgebildet ist, wobei der Haltebereich (13) so dimensioniert ist, daß er das Geflechtsband (9) nicht durchdringen kann.

5. Vorrichtung nach Anspruch 4, **dadurch gekennzeichnet**, daß der Sicherungsstift (15) eine Verriegelungseinrichtung (17) aufweist.

6. Vorrichtung nach Anspruch 5, **dadurch gekennzeichnet**, daß die Verriegelungseinrichtung als den Sicherungsstift (15) durchdringender Draht (17) ausgebildet ist.

7. Vorrichtung nach Anspruch 6, **dadurch gekennzeichnet**, daß der Draht (17) in das Geflechtband (9) integriert ist und der Sicherung mehrerer Halterungen (5) dient.

8. Vorrichtung nach Anspruch 6 oder 7, **dadurch gekennzeichnet**, daß der Draht (17) im Geflechtband (9) verankerbar ist, vorzugsweise durch einen mit dem Geflechtband in Eingriff tretende Öse (19).

9. Vorrichtung nach einem der vorhergehenden Ansprüche, **dadurch gekennzeichnet**, daß die dem Substrat (1) zugewandte Oberfläche (7) der Halterungen (5) mindestens eine die Berührungsfläche zwischen Halterung und Substrat vermindernde Rippe aufweist.

10. Vorrichtung nach einem der vorhergehenden Ansprüche, **dadurch gekennzeichnet**, daß pro Substrat (1) mindestens zwei, vorzugsweise mindestens vier Halterungen (5) vorgesehen sind.

11. Vorrichtung nach einem der vorhergehenden Ansprüche, **dadurch gekennzeichnet**, daß die Halterungen aus Keramik, vorzugsweise aus Aluminiumoxid (Al₂O₃) bestehen.

12. Vorrichtung nach einem der vorhergehenden Ansprüche, **dadurch gekennzeichnet**, daß die Halterungen (5) als Formpreßteile herstellbar sind.

13. Vorrichtung nach einem der vorhergehenden Ansprüche, **dadurch gekennzeichnet**, daß mehrere neben- oder hintereinander angeordnete Reihen von Halterungen (5) auf dem Geflechtband (9) verankerbar sind.

## Claims

1. Apparatus for firing printed substrates, in particular thick-film substrates, having a braided belt which supports the substrates and conveys them through a tunnel ki1n, characterized by holders (5) which are fitted to the braided belt (9) and serve to support the printed substrates (1) in their edge regions.

2. Apparatus according to Claim 1, characterized in that the holders (5) have a wedge shape and a holding region (13) whose surface (7) which slopes downwards at an angle in the direction of the braided belt (9) serves as support surface for the substrate which is preferably printed on both sides.

3. Apparatus according to Claim 1 or 2, characterized in that the holders (5) are provided with a securing region (15) which engages in the braided belt (9).

4. Apparatus according to Claim 3, characterized in that the securing region is configured as a securing pin (15) which penetrates through the mesh of the braided belt (9), with the holding region (13) being dimensioned such that it cannot penetrate through the braided belt (9).

5. Apparatus according to Claim 4, characterized in that the securing pint (15) has a locking device (17).

6. Apparatus according to Claim 5, characterized in that the locking device is configured as a wire (17) running through the securing pin (15).

7. Apparatus according to Claim 6, characterized in that the wire (17) is integrated into the braided belt (9) and serves to secure a plurality of holders (5).

8. Apparatus according to Claim 6 or 7, characterized in that the wire (17) can be anchored in the braided belt (9), preferably by means of an eyelet (19) which engages into the braided belt.

9. Apparatus according to any of the preceding claims, characterized in that the surface (7) of the holders (5) which faces the substrate (1) has at least one ridge which reduces the contact area between holder and substrate.

10. Apparatus according to any of the preceding claims, characterized in that at least two, preferably at least four, holders (5) are provided per substrate (1).

11. Apparatus according to any of the preceding claims, characterized in that the holders are made of ceramic, preferably aluminium oxide (Al₂O₃).

12. Apparatus according to any of the preceding claims, characterized in that the holders (5) can be produced as shaped pressed parts.

13. Apparatus according to any of the preceding claims, characterized in that a plurality of rows, which may be arranged beside or behind one another, of holders (5) can be anchored on the braided belt (9).

## Revendications

1. Dispositif pour cuire des substrats imprimés, notamment des substrats en couches épaisses, comprenant une bande tressée portant les substrats et les transportant à travers un four à passage,
caractérisé par
des moyens de support (5) intégrés à la bande tressée (9) pour soutenir les substrats imprimés dans la zone de leurs bords.

2. Dispositif selon la revendication 1,
caractérisé en ce que
les moyens de support (5) sont en forme de coins et comportent une zone de support (13) dont la surface (7) descendant suivant un angle dans la direction de la bande tressée (9) sert de surface d'appui pour le substrat, de préférence imprimé sur ses deux faces.

3. Dispositif selon la revendication 1 ou 2,
caractérisé en ce que
les moyens de support (5) sont munis d'une zone de fixation (15) en prise avec la bande tressée (9).

4. Dispositif selon la revendication 3,
caractérisé en ce que
la zone de fixation est constituée par une broche de fixation (15) traversant les mailles de la bande tressée (9), la zone de fixation (13) étant dimensionnée pour qu'elle ne puisse pas traverser la bande tressée (9).

5. Dispositif selon la revendication 4,
caractérisé en ce que
la broche de fixation (15) comporte un moyen de verrouillage (17).

6. Dispositif selon la revendication 5,
caractérisé en ce que
le moyen de verrouillage est un fil (17) traversant la broche de fixation (15).

7. Dispositif selon la revendication 6,
caractérisé en ce que
le fil (17) est intégré à la bande tressée (9) et sert à la fixation de plusieurs moyens de support (5).

8. Dispositif selon la revendication 6 ou 7,
caractérisé en ce que
le fil (17) est accroché à la bande tressée (9), de préférence dans un oeillet (19) en prise dans la bande tressée.

9. Dispositif selon l'une des revendications précédentes,
caractérisé en ce que
la surface (7) du moyen de support (5), tournée vers le substrat (1), comporte au moins une nervure évitant une surface de contact entre le moyen de support et le substrat.

10. Dispositif selon l'une des revendications précédentes,
caractérisé en ce que
pour chaque substrat (1) il y a au moins deux et de préférence quatre moyens de fixation (5).

11. Dispositif selon l'une des revendications précédentes,
caractérisé en ce que
les moyens de fixation sont en matière céramique, de préférence en oxyde d'aluminium (Al₂O₃).

12. Dispositif selon l'une des revendications précédentes, caractérisé en ce que
les moyens de fixation (5) sont réalisés sous la forme de pièces moulées à la presse.

13. Dispositif selon l'une des revendications précédentes,
caractérisé par
plusieurs rangées de moyens de support (5) sont accrochées à la bande tressée (9), ces rangées étant juxtaposées ou placées les unes derrière les autres.
